# EUROPEAN PATENT APPLICATION

(11) **EP 4 675 721 A1**
(43) Date of publication of application: **07.01.2026**
(21) Application number: 23925353.7
(22) Date of filing: 13.09.2023
(51) Int. Cl.: H01M 10/04, H01M 10/058

(54) **QUALITY MANAGEMENT DEVICE, QUALITY MANAGEMENT SYSTEM, QUALITY MANAGEMENT PROGRAM, AND QUALITY MANAGEMENT METHOD**

(30) Priority: 01.03.2023 JP 2023031049
(71) Applicant: HITACHI HIGH-TECH CORPORATION, Tokyo 105-6409 (JP)
(72) Inventor: AMASAKI, Shimpei, Tokyo 100-8280 (JP); TAKAHARA, Toshiyuki, Suntougun, Shizuoka 4101313 (JP); SHINOHARA, Keiichiro, Tokyo 105-6409 (JP); TAKEZAKI, Taiichi, Tokyo 105-6409 (JP); TAJIRI, Rikiya, Tokyo 105-6409 (JP)
(74) Representative: Strehl & Partner mbB
(86) International application number: PCT/JP2023/033351
(87) International publication number: WO 2024/180799

(57) **Abstract**

Provided is a quality management device capable of reducing production loss cost by predicting a yield in a battery inspection process based on foreign matter inspection data of a battery material or a product in process.

A quality management device 10 includes: a model storage unit 11 configured to store a relational expression that formulates a relation between foreign matter inspection data from a foreign matter inspection device 21 configured to measure a foreign matter mixed as an impurity in a battery material or a product in process in a battery production process (an electrode production process 31 and a cell production process 32) and battery inspection data from a battery inspection device 22 configured to inspect, in a battery inspection process 33, electrical characteristics of a battery produced in the battery production process; a yield prediction value calculation unit 12 configured to calculate a yield prediction value in the battery inspection process using the relational expression of the model storage unit 11 with the foreign matter inspection data as an input; and a yield prediction value display unit 13 configured to display the yield prediction value on a display device 23.

## Description

### Technical Field

The present invention relates to a quality management device, a quality management system, a quality management program, and a quality management method.

### Background Art

The abstract of PTL 1 states that, "A production method for a secondary battery includes: a position information acquisition step of acquiring identification information of an electrode material to be used for assembly and a position of a portion to be used in the electrode material to be used for the assembly; a quality information acquisition step of acquiring quality information of the portion to be used in the electrode material based on the acquired identification information and position; and a used portion determination step of determining a portion to be actually used for assembly in the electrode material based on the acquired quality information".

### Citation List

### Patent Literature

PTL 1: JP2009-266739A

### Summary of Invention

### Technical Problem

A secondary battery represented by a lithium ion battery can store electric energy, is used for in-vehicle applications and the like, and is repeatedly charged and discharged. For example, when a foreign matter present in a material or an atmosphere or a foreign matter generated from a production facility is mixed into a battery in the process of producing the battery, a micro-short circuit occurs in the battery to cause self-discharge, and battery performance such as storage of electric energy deteriorates. Therefore, in a battery inspection process (aging process), a battery in which a micro-short circuit occurs is selected by measuring a self-discharge amount or the like. Since the sorting of the battery causes a decrease in yield, it is preferable to detect a material or a product in process mixed with a foreign matter in the process of producing the battery and discard the material or the product in process to prevent the material or the product in process from flowing out to a subsequent process.

However, depending on a foreign matter state (for example, an elemental composition, a volume, or a mixed amount), it may or may not cause the self-discharge in the battery, and a countermeasure of discarding all materials or products in process that are mixed with a foreign matter can result in excessive reduction in yield and increased production loss cost. From the viewpoint of reducing the production loss cost, it is necessary to predict the yield in a battery inspection process according to the foreign matter state.

PTL 1 discloses a method for measuring defect information in an electrode material and determining a portion to be used for assembly and, conversely, a portion to be discarded, but does not consider a foreign matter and does not describe predicting a yield in a battery inspection process according to the foreign matter state.

An object of the invention is to provide a quality management device, a quality management system, a quality management program, and a quality management method capable of reducing production loss cost by predicting a yield in a battery inspection process based on foreign matter inspection data of a battery material or a product in process.

### Solution to Problem

In order to solve the above-described problem, a quality management device according to the invention includes: a model storage unit configured to store a relational expression that formulates a relation between foreign matter inspection data from a foreign matter inspection device configured to measure a foreign matter mixed as an impurity in a battery material or a product in process in a battery production process and battery inspection data from a battery inspection device configured to inspect, in a battery inspection process, electrical characteristics of a battery produced in the battery production process; a yield prediction value calculation unit configured to calculate a yield prediction value in the battery inspection process using the relational expression with the foreign matter inspection data as an input; and a yield prediction value display unit configured to display the yield prediction value on a display device.

A quality management system according to the invention includes: the quality management device and the foreign matter inspection device.

A quality management program according to the invention causes a computer system to function as: the model storage unit, the yield prediction value calculation unit, and the yield prediction value display unit.

A quality management method according to the invention includes: calculating a yield prediction value in a battery inspection process using foreign matter inspection data obtained by measuring a foreign matter mixed as an impurity in a battery material or a product in process in a battery production process, and a relational expression that formulates a relation between the foreign matter inspection data and battery inspection data obtained by inspecting, in the battery inspection process, electrical characteristics of a battery produced in the battery production process; and displaying the yield prediction value.

### Advantageous Effects of Invention

According to the invention, it is possible to reduce production loss cost by predicting a yield in a battery inspection process based on foreign matter inspection data of a battery material or a product in process.

Problems, configurations, and effects other than those described above will become apparent in the following description of an embodiment of the invention.

### Brief Description of Drawings

[FIG. 1] FIG. 1 is a functional block diagram showing an example of a quality management device and a quality management system according to Embodiment 1.
[FIG. 2] FIG. 2 is a diagram showing an example of a hardware structure of the quality management device according to Embodiment 1.
[FIG. 3] FIG. 3 is a diagram showing an example of a secondary battery production process to which the quality management system according to Embodiment 1 is applied.
[FIG. 4] FIG. 4 is a flowchart showing an example of configuring a relational expression to be stored in a model storage unit of the quality management device according to Embodiment 1.
[FIG. 5] FIG. 5 is a flowchart showing an example of an operation of the quality management system according to Embodiment 1.
[FIG. 6] FIG. 6 is a functional block diagram showing an example of a quality management device and a quality management system according to Embodiment 5.
[FIG. 7] FIG. 7 is a flowchart showing an example of an operation of the quality management system according to Embodiment 5.

### Description of Embodiments

Hereinafter, embodiments according to the invention will be described with reference to the drawings. The embodiments are examples for describing the invention, and are omitted and simplified as appropriate for clarity of description. The invention can be implemented in various other aspects. Unless otherwise specified, each component may be single or plural.

In order to facilitate understanding of the invention, the position, size, shape, range, and the like of each component shown in the drawings may not represent the actual position, size, shape, range, or the like. Therefore, the invention is not necessarily limited to the positions, sizes, shapes, ranges, or the like disclosed in the drawings.

As examples of various types of information, expressions such as "table", "list", and "queue" may be used for description, and the various types of information may be expressed in other data structures. For example, various types of information such as an "XX table", an "XX list", and an "XX queue" may be "XX information". In describing identification information, when expressions such as "identification information", an "identifier", a "name", an "ID", and a "number" are used, the expressions can be replaced with one another.

When there is a plurality of components having the same or similar functions, the plurality of components may be denoted by the same reference signs added with different subscripts. When it is not necessary to distinguish the plurality of components, the description may be made by omitting the subscripts.

In the embodiments, processing performed by executing a program may be described. Here, a computer executes the program by a processor (for example, a CPU or a GPU) and performs processing defined by the program using a storage resource (for example, a memory), an interface device (for example, a communication port), and the like. Therefore, a subject of the processing performed by executing the program may be the processor. Similarly, the subject of the processing performed by executing the program may be a controller, a device, a system, a computer, or a node including a processor. The subject of the processing performed by executing the program may be a calculation unit and may include a dedicated circuit that performs specific processing. Here, the dedicated circuit is, for example, a field programmable gate array (FPGA), an application specific integrated circuit (ASIC), and a complex programmable logic device (CPLD).

The program may be installed on the computer from a program source. The program source may be, for example, a program distribution server or a computer-readable storage medium. When the program source is the program distribution server, the program distribution server may include a processor and a storage resource for storing a program to be distributed, and the processor of the program distribution server may distribute the program to be distributed to another computer. In the embodiment, two or more programs may be implemented as one program, or one program may be implemented as two or more programs.

### [Embodiment 1]

### <Configuration of Quality Management System 20>

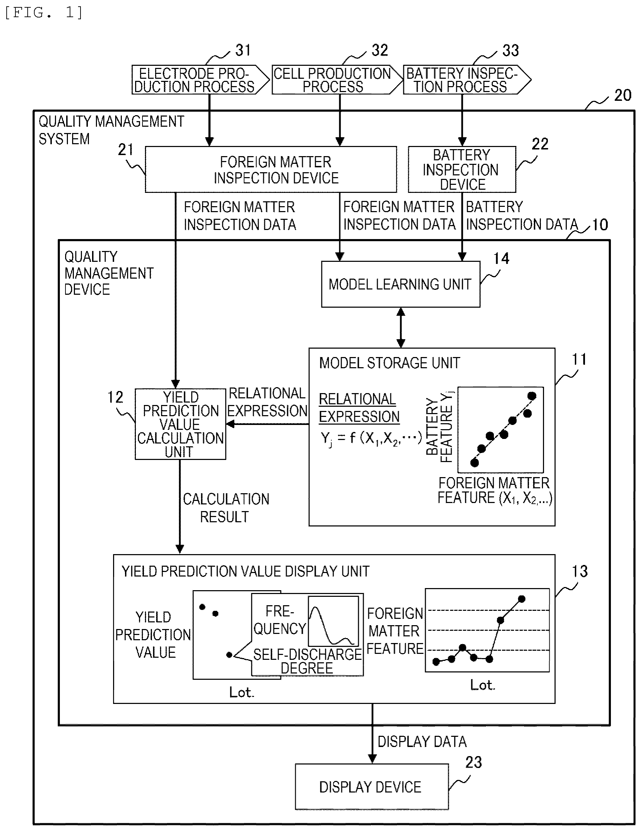

FIG. 1 is a functional block diagram showing an example of a quality management device and a quality management system according to Embodiment 1.

In the present embodiment, an example in which a quality management device 10 and a quality management system 20 are applied to a lithium ion battery production process will be described. The quality management device 10 and the quality management system 20 according to the present embodiment are not limited thereto, and may be applied to a production process of a battery such as a secondary battery other than a lithium ion battery or a primary battery.

The production process of the battery is roughly divided into a battery production process (an electrode production process 31 and a cell production process 32) and a battery inspection process 33. Details of each process will be described later.

The quality management system 20 according to Embodiment 1 includes the quality management device 10, a foreign matter inspection device 21, a battery inspection device 22, and a display device 23. The quality management device 10 includes a model storage unit 11, a yield prediction value calculation unit 12, a yield prediction value display unit 13, and a model learning unit 14.

The foreign matter inspection device 21 is a device that measures a foreign matter mixed as an impurity into a battery material or a product in process in a battery production process. Foreign matter inspection data measured by the foreign matter inspection device 21 is transmitted to the quality management device 10.

As the data measured by the foreign matter inspection device 21, for example, measurement data based on measurement principles such as X-rays represented by a transmission X-ray measurement device or a fluorescent X-ray measurement device, electron beams represented by an electron microscope, visible rays represented by an optical microscope, infrared rays represented by a spectroscopic analysis device, visible rays, ultraviolet rays, and magnetism represented by a magnetic sensor, or data obtained by reconfiguring the measurement data as an image can be used.

Since a foreign matter may be buried not only on a surface of a member such as an electrode or a separator but also inside the member, it is desirable to use X-rays as the measurement principle as a foreign matter measurement method from the viewpoint that the foreign matter can be transmitted to the inside of the member and measured. The foreign matter inspection device 21 measures a foreign matter mixed as an impurity into a battery material or a product in process from at least one or more processes of the electrode production process 31 and the cell production process 32. The electrode production process 31 and the cell production process 32 each have further subdivided processes as to be described later, and the foreign matter inspection device 21 may measure any material or product in process at any timing before, during, or after each of the subdivided processes.

The battery inspection device 22 is a device that inspects electrical characteristics of the battery produced in a battery production process in the battery inspection process 33. Specifically, the battery inspection device 22 measures the electrical characteristics of the battery, and measures the presence or absence of self-discharge of the battery and a degree thereof. Battery inspection data measured by the battery inspection device 22 is transmitted to the quality management device 10.

Examples of the data measured by the battery inspection device 22 include a charge capacity, a discharge capacity, a ratio between the charge capacity and the discharge capacity, a voltage reduction rate, an internal resistance, a self-discharge current, and a combination thereof. When the self-discharge occurs, since electric energy is consumed, an apparent charge capacity necessary for completing charging increases, and an apparent discharge capacity necessary for completing discharging decreases, so that the presence or absence and the degree of the self-discharge can be determined based on the charge capacity, the discharge capacity, and a ratio thereof. Since the electric energy is consumed by self-discharge and a voltage of the battery decreases, the presence or absence and the degree of self-discharge can be determined based on a voltage reduction rate. When an internal short circuit occurs between a positive electrode and a negative electrode, which causes the self-discharge, an internal resistance, which is an electric resistance inside the battery, decreases, and thus the presence or absence and the degree of the self-discharge can be determined based on the internal resistance. When the self-discharge occurs, a self-discharge current can be observed by continuously applying a constant voltage to the battery, so that the presence or absence and the degree of the self-discharge can be determined based on the self-discharge current. Further, in a certain production unit (for example, a production lot or a production date), a probability that a single item or a combination of the battery inspection data is within a standard can be treated as a yield in the battery inspection process 33.

The display device 23 is, for example, a display, is connected to the quality management device 10, and is a device that displays display data transmitted from the quality management device 10.

### <Configuration of Quality Management Device 10>

Next, details of each function in the quality management device 10 will be described. Each function of the quality management device 10 can be achieved by executing a program in the computer system 40 as described later.

The model storage unit 11 stores a relational expression that formulates a relation between the foreign matter inspection data measured by the foreign matter inspection device 21 and the battery inspection data measured by the battery inspection device 22. Since a relational expression is used in the yield prediction value calculation unit 12 described later, one or more relational expressions are stored in the model storage unit 11 in advance before the relational expression is used.

The relational expression stored in the model storage unit 11 is a relational expression for predicting a battery feature Yj calculated based on at least one or more pieces of the battery inspection data from a foreign matter feature (X1, X2,...) calculated based on at least one or more pieces of the foreign matter inspection data, and is represented by, for example, Yj = f (X1, X2,...). As the relational expression, for example, a regression expression or a classifier in which the foreign matter feature is an explanatory variable and the battery feature is an objective variable can be used.

The foreign matter feature is obtained by converting the foreign matter inspection data, and at least one or more of a foreign matter volume, a foreign matter area, a foreign matter thickness, a foreign matter minor axis, a foreign matter major axis, a foreign matter aspect ratio, image data, a foreign matter mixed number and probability, a foreign matter elemental composition, foreign matter inspection data correlated with these, statistics (a mean value, a median value, a maximum value, a minimum value, a standard deviation, a variance, and the like) thereof, a combination thereof, and the like can be used.

As the battery feature, at least one or more of the yield, the charge capacity, the discharge capacity, the ratio between the charge capacity and the discharge capacity, the voltage reduction rate, the internal resistance, the self-discharge current, the statistics thereof (the mean value, the median value, the maximum value, the minimum value, the standard deviation, the variance, and the like), the combination thereof, and the like in the battery inspection process 33 can be used. One relational expression in which the relation between the foreign matter feature and the battery feature is formulated for one battery feature can be configured, and one or more relational expressions are stored in the model storage unit 11.

The yield prediction value calculation unit 12 calculates a yield prediction value in the battery inspection process 33 using the relational expression stored in the model storage unit 11 with the foreign matter inspection data measured by the foreign matter inspection device 21 as an input. The yield prediction value calculation unit 12 may calculate a prediction value of a battery feature other than the yield prediction value together with the yield prediction value.

Specifically, the yield prediction value calculation unit 12 calculates the foreign matter feature based on the foreign matter inspection data, and calculates the prediction value of the battery feature using the relational expression. For example, when a relational expression that formulates the relation between the yield, which is one of the battery features, and the foreign matter feature, is used, the yield prediction value can be directly calculated. In addition, when using a relational expression in which a relation between one of the charge capacity, the discharge capacity, the ratio of the charge capacity to the discharge capacity, the voltage reduction rate, the internal resistance, and the self-discharge current, which are the battery features, and the foreign matter feature is formulated, the prediction value of the battery feature corresponding to the relational expression can be calculated, and the prediction value of the degree of the self-discharge can be calculated based on a calculation result. Then, the yield prediction value can be indirectly calculated based on the prediction value of the degree of the self-discharge.

The yield prediction value calculation unit 12 outputs the calculation result to the yield prediction value display unit 13. In addition, the yield prediction value calculation unit 12 may output, to the yield prediction value display unit 13, not only the yield prediction value but also the prediction value of the battery feature other than the foreign matter feature or the yield prediction value used for calculation.

The yield prediction value display unit 13 displays on the display device 23 the yield prediction value calculated by the yield prediction value calculation unit 12. At this time, data other than the yield prediction value, for example, at least one of the prediction value of the degree of the self-discharge, the prediction value of another battery feature, and the foreign matter feature may be displayed. Each value may be displayed for each production unit (for example, a production lot or a production date). Here, as the display data to be displayed on the display device 23, a graph in which a horizontal axis indicates the production lot (Lot.) and a vertical axis indicates the yield prediction value, a graph in which a horizontal axis indicates a self-discharge degree which is the prediction value of the degree of the self-discharge and the vertical axis indicates a frequency, and a graph in which a horizontal axis indicates the production lot (Lot.) and a vertical axis indicates the foreign matter feature are displayed as details at each point on the graph.

The yield prediction value display unit 13 may have a function of warning a worker by displaying a warning on the display device 23 when the yield prediction value deviates from a preset range of a management value.

The model learning unit 14 configures a relational expression in which a relation between the foreign matter inspection data measured by the foreign matter inspection device 21 and the battery inspection data measured by the battery inspection device 22 is formulated, and stores the configured relational expression in the model storage unit 11. The model learning unit 14 may have a function of reading the relational expression stored in the model storage unit 11, updating the relational expression based on additional foreign matter inspection data and additional battery inspection data, and storing the updated relational expression in the model storage unit 11.

Specifically, the model learning unit 14 calculates the foreign matter feature based on the foreign matter inspection data, calculates the battery feature based on the battery inspection data, and configures or updates the relational expression using statistics, a machine learning method, or the like based on the foreign matter feature and the battery feature.

When the function of the model learning unit 14 is implemented outside the quality management device 10 in advance and the relational expression configured in advance is stored in the model storage unit 11, the model learning unit 14 may be omitted. In this case, since it is not necessary to input the battery inspection data from the battery inspection device 22 to the quality management device 10, the battery inspection device 22 may not be included in the quality management system 20.

### <Hardware structure of Quality Management Device 10>

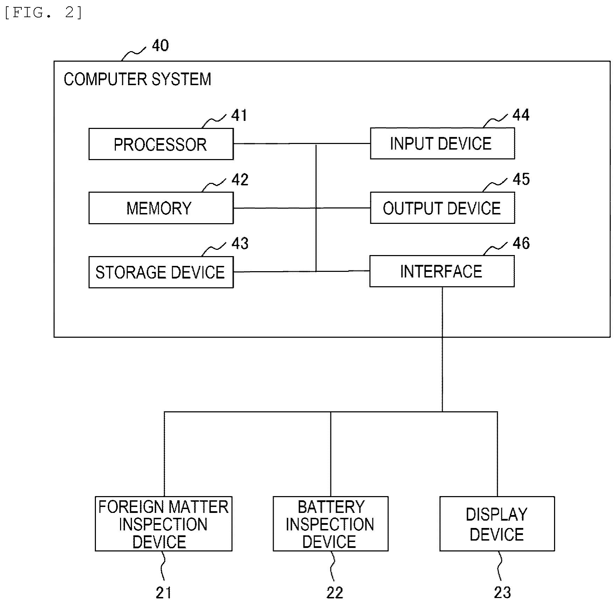

FIG. 2 is a diagram showing an example of a hardware structure of a quality management device according to Embodiment 1.

Each function of the quality management device 10 can be achieved by executing a program in the computer system 40. The computer system 40 includes a processor 41, a memory 42, a storage device 43, an input device 44, an output device 45, and an interface 46.

The interface 46 is connected to the foreign matter inspection device 21, the battery inspection device 22, and the display device 23. A device storing the foreign matter inspection data may be connected instead of the foreign matter inspection device 21, and a device storing the battery inspection data may be connected instead of the battery inspection device 22. A display device of the output device 45 included in the computer system 40 may be used instead of the display device 23.

The input device 44 includes a keyboard, a mouse, and a touch panel (not shown). The output device 45 includes a display device (display) and a speaker (not shown). The storage device 43 includes a non-volatile storage medium and stores data of the model storage unit 11 and the like.

A quality management program for implementing the model storage unit 11, the yield prediction value calculation unit 12, the yield prediction value display unit 13, and the model learning unit 14 is loaded into the memory 42 and executed by the processor 41.

The processor 41 operates as a functional unit that provides a predetermined function by performing processing according to the program of each functional unit. For example, the processor 41 functions as the yield prediction value calculation unit 12 by performing processing according to a yield prediction value calculation program. The same applies to other programs. The data stored in the model storage unit 11 is stored in the memory 42 or the storage device 43. The processor 41 also operates as a functional unit that provides functions of a plurality of processing executed by programs. The computer system 40 is a system including these functional units.

### <Description of Secondary Battery Production Process>

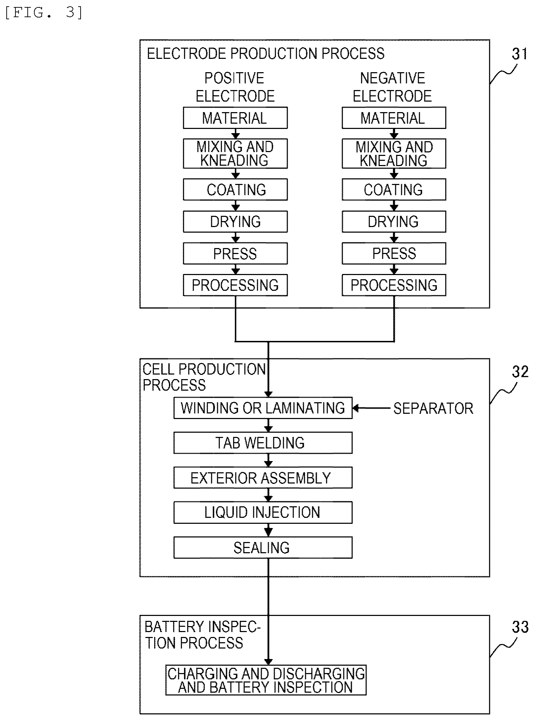

FIG. 3 is a diagram showing an example of a secondary battery production process to which the quality management system according to Embodiment 1 is applied.

In the electrode production process 31, a positive electrode and a negative electrode are produced. One or more materials constituting the positive electrode, such as an active material, a conductive assistant, and a binder, is mixed and kneaded to prepare a positive electrode slurry. The slurry is applied to a metal foil that is a current collector foil, dried, and pressed to obtain a positive electrode sheet. Further, the positive electrode sheet is processed into a predetermined shape. In this manner, the positive electrode can be produced. The negative electrode can be produced in the same manner as the positive electrode. Although the method in which the slurry is applied to the current collector foil and then dried and pressed is described as an example, a drying process and a pressing process may be omitted depending on the material constituting a battery, such as a solid-state (variously called solid, semi-solid, quasi-solid, pseudo-solid, and the like) battery.

As one form of the cell production process 32, a wound body is produced through a process of disposing a separator to be described later between the positive electrode and the negative electrode produced in the electrode production process 31 and winding the separator. As another form of the cell production process 32, a laminated body is manufactured through a process of disposing and laminating the separator between the positive electrode and the negative electrode prepared in the electrode production process 31. The separator is a member that enables a movement of Li ions while preventing physical contact between the positive electrode and the negative electrode. When an electrolytic solution to be described later is used, the separator includes a porous material for holding the electrolytic solution. In addition, in the case of a solid-state battery, the separator may include a solid-state electrolyte that is a material that enables a movement of Li ions while preventing physical contact between the positive electrode and the negative electrode. In a tab welding process, the wound body or the laminated body (hereinafter, may be collectively referred to as an electrode group) is welded to a current collecting member for extracting electricity from a tab formed on an electrode (positive electrode or negative electrode). Further, in an exterior assembly process, the electrode group is placed in an exterior body of the battery (for example, a battery can or a laminate sheet), and the exterior body is sealed by welding, thermocompression bonding, or the like. Thereafter, in a liquid injection process, the electrolytic solution is injected, and in a sealing process, a liquid injection hole is sealed. In this way, the battery cell can be produced. Although the method for winding or laminating is described as an example, the invention is not limited to the method, and any production method of a secondary battery can be widely applied. The liquid injection process may be omitted depending on the material constituting a battery such as a solid-state battery.

In the battery inspection process 33, the electrical characteristics of the battery cell produced in the cell production process 32 are inspected. For example, the method includes a process of inspecting a battery capacity by charging and discharging the battery once or more, and a process of inspecting the presence or absence of the self-discharge of the battery and the degree thereof. Methods for inspecting the presence or absence of the self-discharge of the battery and the degree thereof include a charge or discharge inspection, a voltage reduction inspection, an internal resistance inspection, a self-discharge current inspection, and the like, and the presence or absence of the self-discharge of the battery and the degree thereof can be inspected by one or a combination of these inspections.

During such battery production processes, the foreign matter may be mixed into the battery material, the foreign matter attached to a worker or the foreign matter present in an atmosphere may be mixed into the material or the product in process, the foreign matter generated by scraping of a production facility or piping may be mixed into the product in process, or shavings from processing battery members may be mixed into the product in process as the foreign matter.

The foreign matters that can be mixed as impurities into the battery material and the product in process include metal particles such as pure metals and alloys, ceramic particles such as metal oxides and glass, carbon particles, organic substances, and composites thereof. For convenience, for the shape, the expression "particles" is intended to include not only spheres but also distorted shapes such as shavings, burrs, foils, and fibers. In addition, as the element of the foreign matter, not only particles having an elemental composition which is not used in a positive electrode material or a negative electrode material of a battery but also particles with non-standard shapes or sizes even in an elemental composition used in a positive electrode material or a negative electrode material of a battery are treated as the foreign matter. If the foreign matter is mixed, when the battery is operating, the foreign matter may act as a starting point to damage or break the separator between the positive electrode and the negative electrode, causing the positive electrode and the negative electrode to come into contact and resulting in an internal short circuit, or the foreign matter may dissolve at the positive electrode and precipitate at the negative electrode, penetrating the separator and causing the positive electrode and the negative electrode to come into contact through a precipitate, resulting in an internal short circuit. Since the internal short circuit causes excessive self-discharge of the battery, performance of the battery deteriorates.

In particular, even when the foreign matter containing metal particles has a minute size of about several tens of µm, the foreign matter may be dissolved in the positive electrode, the foreign matter may be precipitated in the negative electrode, and the precipitate may penetrate the separator to cause an internal short circuit. Since the foreign matter is fairly minute, the management is difficult, and higher quality management is required.

Therefore, by applying the quality management system 20 according to the present embodiment, it is possible to predict the yield before the battery inspection process 33, so that it is possible to perform advanced quality management.

### <Example of Relational Expression Configuration Flow>

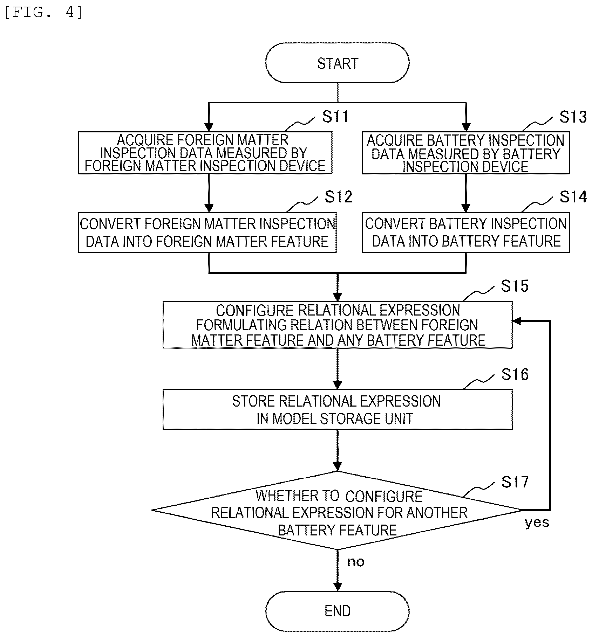

FIG. 4 is a flowchart showing an example of configuring a relational expression to be stored in a model storage unit of the quality management device according to Embodiment 1.

In step S11, the model learning unit 14 acquires the foreign matter inspection data measured by the foreign matter inspection device 21. In step S12, the model learning unit 14 converts the acquired foreign matter inspection data into a foreign matter feature.

In step S13, the model learning unit 14 acquires the battery inspection data measured by the battery inspection device 22 for a battery produced using a battery material or a product in process measured by the foreign matter inspection device 21. In step S14, the model learning unit 14 converts the acquired battery inspection data into a battery feature.

In step S15, the model learning unit 14 configures a relational expression in which a relation between one or more foreign matter features and any battery feature is formulated. More specifically, a regression expression or a classifier in which the foreign matter feature is an explanatory variable and the battery feature is an objective variable is configured as the relational expression. In step S16, the model learning unit 14 stores the configured relational expression in the model storage unit 11. In step S17, when a relational expression is to be configured for another battery feature (yes), the processing returns to step S15, and when no further relational expression is to be configured (no), the processing ends.

### <Example of Operation of Quality Management System 20>

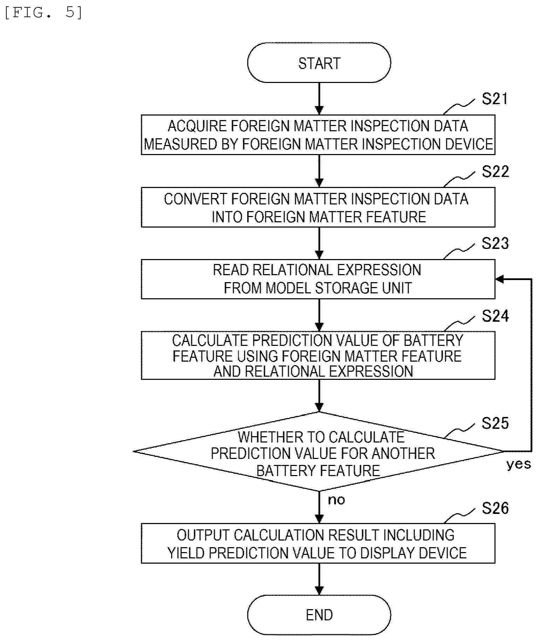

FIG. 5 is a flowchart showing an example of an operation of the quality management system according to Embodiment 1.

In step S21, the yield prediction value calculation unit 12 acquires the foreign matter inspection data measured by the foreign matter inspection device 21. In step S22, the yield prediction value calculation unit 12 converts the acquired foreign matter inspection data into a foreign matter feature. In step S23, the yield prediction value calculation unit 12 reads a relational expression for predicting any battery feature based on the foreign matter feature from the model storage unit 11. In step S24, the prediction value of the battery feature is calculated using the foreign matter feature and the relational expression. In step S25, when another battery feature is calculated (yes), the processing returns to step S23, and when the battery feature is not calculated any more (no), the processing proceeds to the next step S26. When the yield prediction value is directly calculated, a yield prediction value is included in a prediction value of the battery feature in the loop from step S23 to step S25. When the yield prediction value is indirectly calculated, a step in which the yield prediction value calculation unit 12 calculates the yield prediction value based on the prediction value of the battery feature calculated in the loop from step S23 to step S25 may be added between step S25 and step S26. In step S26, the yield prediction value display unit 13 outputs a calculation result including the yield prediction value to the display device.

### <Effects>

According to Embodiment 1, production loss cost can be reduced by predicting the yield in the battery inspection process 33 based on the foreign matter inspection data of the battery material and the product in process. Specifically, in the stage of the upstream battery production process such as the electrode production process 31 or the cell production process 32, since the yield in the battery inspection process 33 can be predicted before the downstream battery inspection process 33 is performed, it is possible to determine whether the material or the product in process in which the foreign matter is mixed is to be discarded from the yield prediction value. Therefore, for example, when the yield prediction value is high, it is also possible to determine that the production is continued without discarding the material or the product in process in which the foreign matter is mixed. Accordingly, excessive discard of all materials and product in process in which the foreign matter is mixed is reduced, so that the production loss cost can be reduced.

Since the yield prediction value can be known in advance, when the yield prediction value deviates from the range of the preset management value, it is possible to take a countermeasure of warning the worker.

### [Embodiment 2]

### <Example of Foreign Matter Inspection Device 21>

Embodiment 2 is a modification in which a foreign matter inspection device using X-rays as a measurement principle is used as the foreign matter inspection device 21 in Embodiment 1. Here, it is desirable that the foreign matter feature includes image data obtained by mapping foreign matter measurement information by X-rays.

Specifically, for example, foreign matter inspection data of an electrode formed in a sheet shape, which is one product in process, and foreign matter inspection data of a separator, which is one of battery materials, are measured using the foreign matter inspection device 21 using the X-rays as the measurement principle. As the battery material and the product in process to be measured by the foreign matter inspection device 21, any material and product in process may be measured at any timing before, during, and after each process of FIG. 3, but from the viewpoint of measuring the electrode or the separator formed in a sheet shape, it is preferable to measure one or more of the battery material and the product in process at any timing before, during, and after coating, drying, pressing, processing, winding, or laminating processes.

An electrode such as a positive electrode or a negative electrode produced in the electrode production process 31 may be a sheet-shaped electrode member having a thickness of several tens of µm to several hundreds of µm by applying an electrode slurry to an electrode foil in a coating process. The separator may be a sheet-shaped member having a thickness of several tens of µm. In such a thick electrode or separator, foreign matters are not necessarily exposed on surfaces of the electrode or the separator, and may be buried and mixed in the electrode or the separator. In order to measure the foreign matter buried in the electrode or the separator, it is preferable to perform measurement using a foreign matter inspection device operating on a measurement principle of penetration through a member. For example, transmission x-rays or fluorescent X-rays can be transmitted through the electrode or the separator and measured.

In the transmission X-ray measurement device, the electrode or the separator is irradiated with the X-rays, and an intensity (may be referred to as luminance) of the transmitted x-rays is measured. When the X-rays pass through the electrode or the separator, the X-rays are absorbed, and the luminance of the transmission x-rays decreases. When the foreign matter is present, an amount of X-ray absorption differs between the foreign matter and the electrode or the separator, and thus the luminance of the transmission x-rays decreases or increases as compared with a portion where no foreign matter is present. Therefore, by mapping a luminance change amount of the transmission x-rays, it is possible to measure the presence or absence of a foreign matter, information related to the size of the foreign matter, and the like as the foreign matter inspection data.

Examples of the foreign matter inspection data that can be measured by the transmission X-ray measurement device include foreign matter measurement information such as luminance or a luminance change amount of the transmission X-rays, image data obtained by mapping the foreign matter measurement information such as the luminance or the luminance change amount of the transmission X-rays, and the number of detected foreign matters. The foreign matter inspection data can be used as the foreign matter feature. In addition, as the foreign matter feature, the foreign matter inspection data can be converted and the foreign matter volume, the foreign matter area, the foreign matter thickness, the foreign matter minor axis, the foreign matter major axis, the foreign matter aspect ratio, the image data, the foreign matter mixed number and probability, the foreign matter inspection data correlated with these, the statistics (the mean value, the median value, the maximum value, the minimum value, the standard deviation, the variance, and the like) thereof, a combination thereof, and the like can be used.

In a fluorescent X-ray measurement device, the electrode or the separator is irradiated with the X-rays, and the energy of the fluorescent X-rays is measured. Since the energy of the fluorescent X-rays has an element-specific value, the elemental composition can be identified based on the energy of the fluorescent X-rays. When a foreign matter is present, the elemental composition of the foreign matter differs from that of the electrode and the separator, and thus the fluorescent X-rays with different energies are measured. By mapping the energy of the fluorescent X-rays, the presence or absence of the foreign matter, the size of the foreign matter, information related to the foreign matter elemental composition, and the like can be measured as the foreign matter inspection data.

Examples of the foreign matter inspection data that can be measured by the fluorescent X-ray measurement device include foreign matter measurement information such as the energy of fluorescent X-rays, the image data obtained by mapping the foreign matter measurement information such as the energy of the fluorescent X-rays, and the number of detected foreign matters. The foreign matter inspection data can be used as the foreign matter feature. As the foreign matter feature, the foreign matter inspection data can be converted and the foreign matter volume, the foreign matter area, the foreign matter thickness, the foreign matter minor axis, the foreign matter major axis, the foreign matter aspect ratio, the image data, the foreign matter mixed number and probability, the foreign matter elemental composition, the foreign matter inspection data correlated with these, the statistics (the mean value, the median value, the maximum value, the minimum value, the standard deviation, the variance, and the like) thereof, a combination thereof, and the like can be used.

When the foreign matter inspection device using the X-rays as the measurement principle is used, it is desirable that the foreign matter feature includes the image data obtained by mapping the foreign matter measurement information by the X-rays. Accordingly, highly accurate prediction using machine learning is possible.

Other parts are the same as those of Embodiment 1.

### <Effects>

According to Embodiment 2, since the X-rays are used as the measurement principle, it is possible to measure the foreign matter inspection data and predict the battery feature including the yield in the battery inspection process 33 even if the foreign matter is mixed into the battery material such as the electrode and the separator and the inside of the product in process. Accordingly, the yield in the downstream battery inspection process 33 can be predicted with higher accuracy in an upstream production process of the battery material or the product in process. When the fluorescent X-ray measurement device is used, information related to the foreign matter elemental composition can be measured as the foreign matter inspection data, so that the foreign matter elemental composition can be used as the foreign matter feature.

In addition, it is possible to perform highly accurate prediction using the machine learning by including the image data obtained by mapping the foreign matter measurement information by the X-rays as the foreign matter feature.

### [Embodiment 3]

### <Example of Placement of Foreign Matter Inspection Device 21>

Embodiment 3 is a modification in which the foreign matter inspection device 21 according to Embodiment 1 is incorporated in a production facility to be used in a battery production process.

Specifically, the foreign matter inspection device 21 is incorporated into at least one production facility among production facilities used in battery production processes such as the electrode production process 31 and the cell production process 32, and the foreign matter inspection data is measured. The incorporation into the production facility will be specifically described below.

For example, a foreign matter inspection device using the transmission x-rays as the measurement principle includes a portion that irradiates a battery material or a product in process as a measurement target with X-rays and a portion that detects the transmission x-rays. The incorporation of the foreign matter inspection device into the production facility means that a portion that emits the X-rays and a portion that detects the transmission x-rays are provided in the production facility.

For example, the electrode is formed in a sheet shape in the coating process of the electrode production process 31, and thereafter, in the subsequent processes (coating, drying, pressing, processing, winding, or laminating), the electrode is conveyed in a production facility by a roll-to-roll process, a belt conveyor, an air chuck, or the like in a state of a series of sheets or in a state of being cut into any area. By incorporating the foreign matter inspection device into at least one production facility, it is possible to measure the foreign matter inspection data of the battery material or the product in process during conveyance in real time.

Other parts are the same as those of Embodiment 1.

### <Effects>

According to Embodiment 3, the foreign matter inspection data can be measured in real time from the battery material or the product in process, and the battery feature including the yield in the battery inspection process 33 can be predicted. Accordingly, the yield in the downstream battery inspection process 33 can be predicted in real time in the upstream production process of the battery material or the product in process.

### [Embodiment 4]

### <Another Example of Placement of Foreign Matter Inspection Device 21>

Embodiment 4 is a modification in which the foreign matter inspection device 21 according to Embodiment 1 measures a foreign matter between two processes in a battery production process.

Specifically, a foreign matter inspection process including the foreign matter inspection device 21 is newly provided in one or more processes of the electrode production process 31 and the cell production process 32, and the foreign matter inspection data is measured. For example, between the processes of drying, pressing, processing, winding, and laminating, the product in process may be replaced from the production facility in the previous process to the production facility in the subsequent process. At this time, the foreign matter inspection data of the battery material or the product in process can be measured by providing the foreign matter inspection process between one or more processes.

In Embodiment 3, the method for incorporating the foreign matter inspection device into the battery production facility is described, and the existing production facility may not have a space for incorporating the foreign matter inspection device. Therefore, according to the method in Embodiment 4, the foreign matter inspection data can be measured even when there is no space for incorporating the foreign matter inspection device into the existing production facility.

Other parts are the same as those of Embodiment 1.

### <Effects>

According to Embodiment 4, the foreign matter inspection data can be measured even when there is no space for incorporating the foreign matter inspection device in the existing production facility, and the yield in the downstream battery inspection process 33 can be predicted in the upstream production process of the battery material or the product in process.

### [Embodiment 5]

### <Modification of Quality Management Device 10 and Quality Management System 20>

Embodiment 5 is a modification of the quality management device 10 and the quality management system 20 in Embodiment 1.

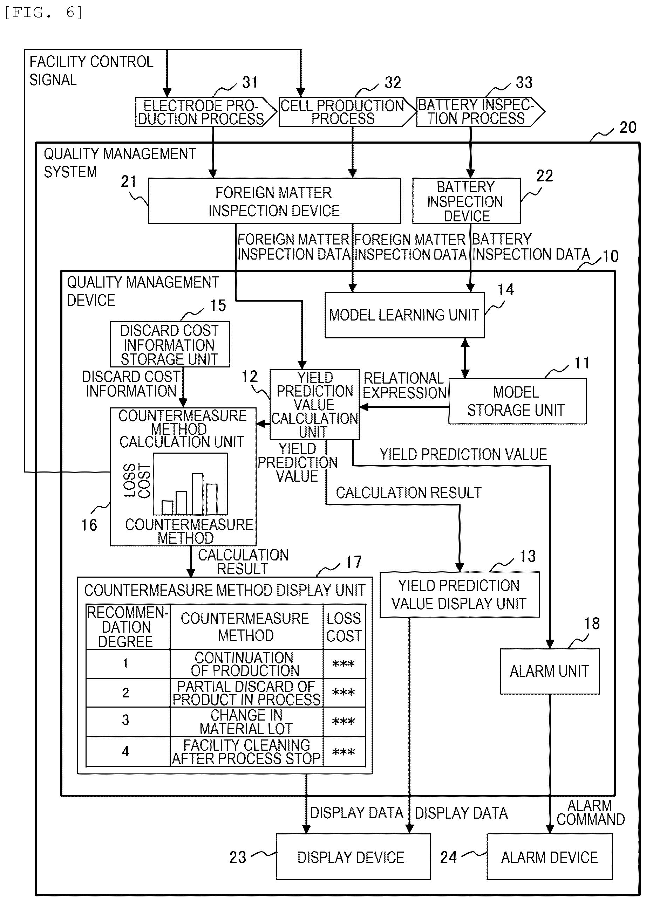

FIG. 6 is a functional block diagram showing an example of a quality management device and a quality management system according to Embodiment 5.

The quality management device 10 in the Embodiment 5 further includes a discard cost information storage unit 15, a countermeasure method calculation unit 16, a countermeasure method display unit 17, and an alarm unit 18 in addition to the configuration of Embodiment 1 described in FIG. 1. The quality management system 20 according to the Embodiment 5 further includes an alarm device 24 in addition to the configuration of Embodiment 1.

Since the configuration common to Embodiment 1 is the same as that of Embodiment 1, the description thereof will be omitted.

The discard cost information storage unit 15 stores in advance discard cost information including at least one or more pieces of information such as a discard cost basic unit of a battery material, a discard cost basic unit of a product in process, a discard cost basic unit of a battery cell, and a production stop cost basic unit.

The discard cost basic unit of the battery material refers to not only the cost of simply discarding the battery material but also the sum of the cost related to the battery material including the procurement and storage cost of the battery material and the cost of discarding the battery material. More specifically, the battery material is a material containing at least one or more of an active material of a positive electrode or a negative electrode, a conductive assistant, a binder, a current collector foil, a separator, an electrolytic solution, and the like.

Similarly, the discard cost basic unit of the product in process refers to not only the cost of discarding the product in process but also the sum of the cost of producing the product in process and the cost of discarding the product in process. More specifically, the product in process refers to a state of one or more of an electrode slurry, an electrode sheet, an electrode group, and the like, and refers to each intermediate product in a process from producing a battery cell from a material to completing the battery inspection process 33.

Similarly, the discard cost basic unit of the battery cell refers to not only the cost of discarding the battery cell but also the sum of the cost of producing the battery cell and the cost of discarding the battery cell. More specifically, the battery cell refers to a battery product after the battery inspection process 33 is performed.

The production stop cost basic unit refers to the cost from the stop of the production process of the secondary battery to the restart of the production.

The countermeasure method calculation unit 16 calculates the production loss cost for each preset countermeasure method based on the yield prediction value calculated by the yield prediction value calculation unit 12 and the discard cost information stored in the discard cost information storage unit 15, and ranks a recommendation degree of the countermeasure method in ascending order of the production loss cost. The countermeasure method is set in advance, and includes, for example, continuation of production, partial discard of the product in process, change in a material lot, and facility cleaning after process stop. A calculation result in the countermeasure method calculation unit 16 is output to the countermeasure method display unit 17.

The countermeasure method display unit 17 displays the countermeasure method and the recommendation degree thereof on the display device 23 based on the calculation result of the countermeasure method calculation unit 16. The production loss cost for each countermeasure method may also be displayed. Here, a case in which the influence of the foreign matter on the yield is small is exemplified, and as the display data to be displayed on the display device 23, an example is shown in which the recommendation degrees of the respective countermeasure methods of the continuation of production, the partial discard of the product in process, the change in the material lot, and facility cleaning after process stop are ranked as 1, 2, 3, and 4, respectively. The production loss cost for each countermeasure method is displayed in a loss cost column. Accordingly, the worker can determine that the production is to be continued. The display device 23 may be the same as the display device that displays the display data from the yield prediction value display unit 13, or may be another display device.

The countermeasure method calculation unit 16 may be implemented to transmit, to the production facility, a control signal for executing a countermeasure method having the highest recommendation degree, that is, a countermeasure method that minimizes the production loss cost, based on the calculated recommendation degree of the countermeasure method. For example, when the process is stopped, a production stop signal is transmitted to the production facility. Accordingly, a countermeasure with a high recommendation degree can be executed in real time without intervention of the worker.

The alarm unit 18 transmits an alarm command to the alarm device 24 when the yield prediction value calculated by the yield prediction value calculation unit 12 deviates from a preset range of the management value.

The alarm device 24 is a device that receives an alarm command from the alarm unit 18, issues an alarm by sound, a lamp, other electronic signals, or the like, and warns the worker. Accordingly, the worker can quickly know that the yield is reduced due to the foreign matter.

Each function of the discard cost information storage unit 15, the countermeasure method calculation unit 16, the countermeasure method display unit 17, and the alarm unit 18 of the quality management device 10 can be achieved by executing a program in the computer system 40, similarly to the description of FIG. 2. The processor 41 shown in FIG. 2 operates as a functional unit that provides a predetermined function by performing processing according to the programs of the functional units. The data stored in the discard cost information storage unit 15 is stored in the memory 42 or the storage device 43. The alarm device 24 is connected to the interface 46.

The configuration added in Embodiment 5 does not necessarily need to be entirely provided, and may be partially provided. For example, only a part of the transmission of a facility control signal by the countermeasure method calculation unit 16, the countermeasure method display unit 17, and the alarm unit 18 may be provided, and others may be omitted.

### <Example of Operation of Quality Management System 20>

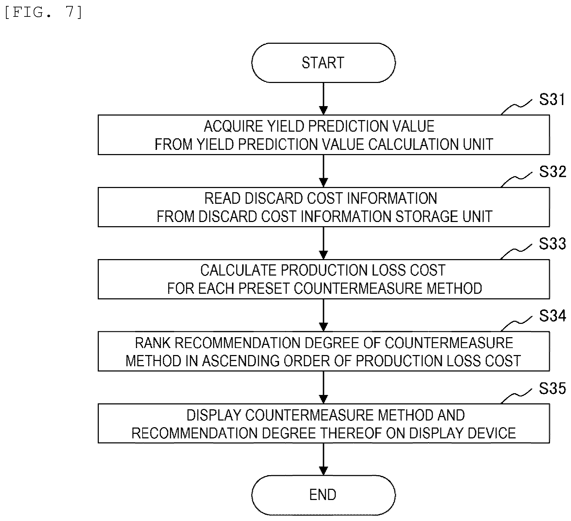

FIG. 7 is a flowchart showing an example of an operation of a quality management system according to Embodiment 5.

In step S31, the countermeasure method calculation unit 16 acquires the yield prediction value from the yield prediction value calculation unit 12. In step S32, the countermeasure method calculation unit 16 reads the discard cost information from the discard cost information storage unit 15. In step S33, the countermeasure method calculation unit 16 calculates the production loss cost for each preset countermeasure method based on the yield prediction value and the discard cost information. In step S34, the countermeasure method calculation unit 16 ranks the recommendation degrees of the countermeasure methods in ascending order of the production loss cost. In step S35, the countermeasure method display unit 17 displays, on the display device 23, the countermeasure method and the recommendation degree thereof.

### <Effects>

According to Embodiment 5, a countermeasure method that minimizes the production loss cost can be presented.

In addition, by transmitting the facility control signal by the countermeasure method calculation unit 16, it is possible to execute a countermeasure with a high recommendation degree in real time without the intervention of the worker.

In addition, by performing the alarm by the alarm unit 18 and the alarm device 24, the worker can quickly know that the yield is reduced due to the foreign matter.

### <Summary>

Although the embodiments of the invention have been described above, the invention is not limited to the above-described embodiments, and includes various modifications. For example, the embodiments described above are described in detail to facilitate understanding of the invention, and the invention is not necessarily limited to those including all the configurations described above. A part of a configuration of a certain embodiment can be replaced with a configuration of another embodiment, and a configuration of another embodiment can be added to a configuration of a certain embodiment. In addition, with respect to a part of a configuration of each embodiment, addition, deletion, or replacement of another configuration can be applied singly or in combination. Further, it is needless to mention that components (also including element steps and the like) thereof are not necessarily essential unless otherwise specified or unless clearly considered to be essential in principle. In addition, when referring to the number or the like of elements (including the number, a numerical value, an amount, a range, or the like), the number of elements is not limited to a specific number, and may be the specific number or more or the specific number or less, unless otherwise specified or except a case where the number is apparently limited to a specific number in principle.

Control lines and information lines indicate what is considered to be necessary for description, and not necessarily all control lines and information lines are always shown on a product. Actually, almost all configurations may be considered to be connected to one another.

### Reference Signs List

10 quality management device
11 model storage unit
12 yield prediction value calculation unit
13 yield prediction value display unit
14 model learning unit
15 discard cost information storage unit
16 countermeasure method calculation unit
17 countermeasure method display unit
18 alarm unit
20 quality management system
21 foreign matter inspection device
22 battery inspection device
23 display device
24 alarm device
31 electrode production process
32 cell production process
33 battery inspection process
40 computer system
41 processor
42 memory
43 storage device
44 input device
45 output device
46 interface

## Claims

1. A quality management device comprising:
a model storage unit configured to store a relational expression that formulates a relation between foreign matter inspection data from a foreign matter inspection device configured to measure a foreign matter mixed as an impurity in a battery material or a product in process in a battery production process and battery inspection data from a battery inspection device configured to inspect, in a battery inspection process, electrical characteristics of a battery produced in the battery production process;
a yield prediction value calculation unit configured to calculate a yield prediction value in the battery inspection process using the relational expression with the foreign matter inspection data as an input; and
a yield prediction value display unit configured to display the yield prediction value on a display device.

2. The quality management device according to claim 1, wherein
the relational expression is a relational expression obtained by formulating a relation between a foreign matter feature calculated based on the foreign matter inspection data and a battery feature calculated based on the battery inspection data.

3. The quality management device according to claim 2, wherein
the foreign matter feature includes at least one or more of a foreign matter volume, a foreign matter area, a foreign matter thickness, a foreign matter minor axis, a foreign matter major axis, a foreign matter aspect ratio, image data, a foreign matter mixed number and probability, a foreign matter elemental composition, foreign matter inspection data correlated with the features, statistics of the features, and a combination of the features, and
the battery feature includes at least one or more of a yield in the battery inspection process, a charge capacity, a discharge capacity, a ratio of the charge capacity to the discharge capacity, a voltage reduction rate, an internal resistance, a self-discharge current, statistics of the features, and a combination of the features.

4. The quality management device according to claim 2, wherein
the foreign matter inspection device is a device using X-rays as a measurement principle.

5. The quality management device according to claim 4, wherein
the foreign matter feature includes image data obtained by mapping foreign matter measurement information by the X-rays.

6. The quality management device according to claim 1, further comprising:
a discard cost information storage unit configured to store discard cost information including at least one or more pieces of information of a discard cost basic unit of the battery material, a discard cost basic unit of the product in process, a discard cost basic unit of a battery cell, and a production stop cost basic unit;
a countermeasure method calculation unit configured to calculate a production loss cost for each of preset countermeasure methods based on the yield prediction value and the discard cost information, and ranks recommendation degrees of the countermeasure methods in ascending order of the production loss cost; and
a countermeasure method display unit configured to display the countermeasure method and a recommendation degree of the countermeasure method on the display device based on a calculation result of the countermeasure method calculation unit.

7. The quality management device according to claim 6, wherein
the countermeasure method calculation unit transmits, to a production facility, a control signal for executing the countermeasure method that minimizes the production loss cost.

8. The quality management device according to claim 1, further comprising:
an alarm unit configured to transmit an alarm command to an alarm device when the yield prediction value deviates from a preset range of a management value.

9. A quality management system comprising:
the quality management device according to claim 1; and
the foreign matter inspection device according to claim 1.

10. The quality management system according to claim 9, wherein
the foreign matter inspection device is incorporated into a production facility to be used in the battery production process.

11. The quality management system according to claim 9, wherein
the foreign matter inspection device is a device configured to measure the foreign matter between two processes in the battery production process.

12. A quality management program for causing a computer system to function as:
the model storage unit, the yield prediction value calculation unit, and the yield prediction value display unit according to claim 1.

13. A quality management method comprising:
calculating a yield prediction value in a battery inspection process using foreign matter inspection data obtained by measuring a foreign matter mixed as an impurity in a battery material or a product in process in a battery production process, and a relational expression that formulates a relation between the foreign matter inspection data and battery inspection data obtained by inspecting, in the battery inspection process, electrical characteristics of a battery produced in the battery production process; and
displaying the yield prediction value.

14. The quality management method according to claim 13, further comprising:
calculating production loss cost for each of preset countermeasure methods based on the yield prediction value and discard cost information including at least one or more pieces of information of a discard cost basic unit of the battery material, a discard cost basic unit of the product in process, a discard cost basic unit of a battery cell, and a production stop cost basic unit;
ranking recommendation degrees of the countermeasure methods in ascending order of the production loss cost; and
displaying the countermeasure method and a recommendation degree of the countermeasure method.

15. The quality management method according to claim 13, further comprising:
calculating production loss cost for each of preset countermeasure methods based on the yield prediction value and discard cost information including at least one or more pieces of information of a discard cost basic unit of the battery material, a discard cost basic unit of the product in process, a discard cost basic unit of a battery cell, and a production stop cost basic unit; and
transmitting, to a production facility, a control signal for executing the countermeasure method that minimizes the production loss cost.
